# EUROPEAN PATENT APPLICATION

(11) **EP 1 860 691 A1**
(43) Date of publication of application: **28.11.2007**
(21) Application number: 06715442.7
(22) Date of filing: 09.03.2006
(51) Int. Cl.: H01L 21/60, H05K 1/11, H05K 3/32, H05K 3/40

(54) **ELECTRONIC CIRCUIT AND METHOD FOR MANUFACTURING SAME**

(30) Priority: 09.03.2005 JP 2005065431
(71) Applicant: Hitachi Kyowa Engineering Co., Ltd., Hitachi-shi, Ibaraki 317-0072 (JP)
(72) Inventor: MATSUSHIMA, Naoki HITACHI, LTD., Yokohama-shi Kanagawa 2440817 (JP); TAKEMORI, Hideaki, cho 3-chome, Hitachi-shi Ibaraki 3170072 (JP)
(74) Representative: Strehl Schübel-Hopf & Partner
(86) International application number: PCT/JP2006/304571
(87) International publication number: WO 2006/095805

(57) **Abstract**

To provide an electronic circuit board in which a conductive wire is excellently connected to a bonding pad formed directly on a polyimide film. The electronic circuit includes: a first layer metal pattern 3 formed on a substrate 1; a polyimide film 2 formed on the first layer metal pattern 3; and a second layer metal pattern formed on a surface of the polyimide film 2. A conductive bump 4 is formed on the surface of the second layer metal pattern 31 by ball-bonding to provide electrical connection with a semiconductor chip 7 bonded to the first layer metal pattern by die-bonding. The conductive bump 4 is electrically connected to an electrode 72 of the semiconductor chip 7 by wire bonding.

## Description

### Background of the Invention

The present invention relates to an electronic circuit and a method for manufacturing the same, more particularly an electronic circuit in which a conductive wire is connected to a bonding pad formed on a surface of a resin insulating film and a method for manufacturing such an electronic circuit.

In recent electronic circuit boards, high density, small size, and wideband characteristics have been required due to the sophisticated specifications. An example of an effective method for meeting the requirements is to form a multilayer wiring in which a thin resin insulating layer such as polyimide film is used on an electronic circuit board. Particularly, in order to downsize high-frequency transmission lines under condition that the impedance is constant, it is necessary to make the interlayer insulating film very thin. In this case, the use of thin film technology is necessary to form metal film on the interlayer insulating film and the insulating film.

Meanwhile, in the electronic circuit board, it is necessary to electrically connect electronic components mounted on a substrate and the substrate, or the substrate and other components. As an effective method for realizing this, there is so called wire bonding for bonding a conductive wire (a metal wire) of Au or Al, and an electrode pad on the electronic component by ultrasonic welding.

In Patent Document 1, there is described a wire bonding method for forming a bump by pulling a wire upward to cut off at the end of a gold ball after ball-bonding, and then performing a second bonding of wire bonding to the bump.

Further in Patent Document 2, there is described a wire bonding method for forming a bump by performing ball-bonding to a conductor of base metal, and then performing wedge bonding to a portion of the base metal conductor, which faces in the opposite direction to a first bonding place of wire bonding that will be performed later.

Further in Patent Document 3, there is described a wire bonding method, which is an improvement of the invention described in Patent Document 1, for forming a bump with a large bonding area by moving a capillary in both vertical and horizontal directions after contacting the gold ball with the base metal conductor.
Patent Document 1: JP-A No. Hei 3(1991)-183139
Patent Document 2: Japanese Patent No. 3344235
Patent Document 3: JP-A No. 2000-357700

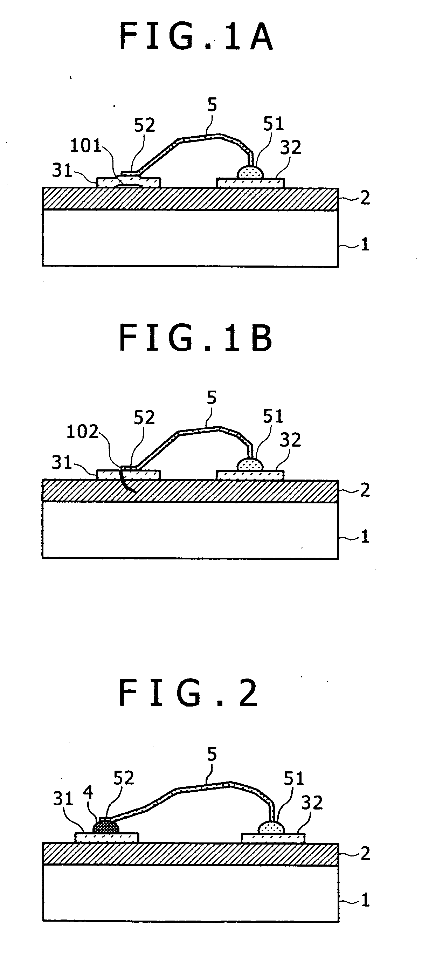

However, when the conductive wire is subjected to the second bonding of wire bonding on the bonding pad formed on the resin insulating film such as polyimide, there arise problems that exfoliation occurs at the interface between the polyimide and the pad due to an ultrasonic output in bonding as shown in Fig. 1Aand that the polyimide itself is broken as shown in Fig. 1B. These prevent the connection from being secured.

The invention described in Patent Document 1 is made for the repair of the wire or IC, and the inventions described in Patent Documents 2 and 3 are made for the base metal conductor. Thus there is no description of the above described problems in the documents.

### Summary of the Invention

The above described problems can be solved by forming a bump on a metal film formed on a resin insulating film formed on a substrate and by ultrasonically bonding a conductive wire to the bump.

### Brief Description of the Drawings

Preferred embodiments of the present invention will now be described in conjunction with the accompanying drawings, in which;
Fig. 1 shows views illustrating problems of a second bonding to a bonding pad on a resin insulating layer;
Fig. 2 is a cross-sectional view of an electronic circuit;
Fig. 3 is a cross-sectional view of an electronic circuit;
Fig. 4 is a cross-sectional view of an electronic circuit;
Fig. 5 is a cross-sectional view of an electronic circuit;
Fig. 6 is a cross-sectional view of an electronic circuit;
Fig. 7 is a cross-sectional view of an electronic circuit;
Fig. 8 is a top view and a cross-sectional view of an optical module;
Fig. 9 is a top view and a cross-sectional view of transmission lines;
Fig. 10 a top view and a cross-sectional view of a semiconductor device; and
Fig. 11 shows views illustrating the manufacturing process of an electronic circuit.

### Description of the Preferred Embodiments

Hereinafter the modes for carrying out the present invention will be described using embodiments with reference to the accompanying drawings.

### [Embodiment 1]

The description will be made of a first embodiment with reference to Figs. 2 to 5. Here Figs. 2 to 5 are cross-sectional views each showing an electronic circuit.

In Fig. 2, a polyimide film 2 is formed on a surface of a substrate 1. More specifically, polyimide precursor is applied to the substrate 1 by spin coating and then cured (thermally cured) at a temperature of 350°C. Incidentally, the patterning may be performed using photosensitive polyimide before curing, or the patterning may be performed using non-photosensitive polyimide by etching with hydrazine through a photoresist process after curing. An aluminum nitride (AlN) substrate was used as a member of the substrate 1. The film thickness of the polyimide film 2 was 2 µm (after curing). According to the knowledge of the inventors, the maximum effect can be achieved when the film thickness of the insulating resin film is in the range of 0.1 to 100 µm.

A first bonding pad 31 and second bonding pad 32 of patterned metal film are formed on the surface of the polyimide film 2. Here the metal film is formed with Ti (titanium), Pt (platinum), Au (gold) (hereinafter referred to as Ti/Pt/Au) in this order from the bottom (the substrate 1 side) sequentially by one evaporation apparatus. The film thicknesses of the laminated structure of Ti/Pt/Au are 0.1 µm, 0.2 µm, 0.5 µm respectively from the substrate 1 side (hereinafter also referred to as "thicknesses of 0.1/0.2/0.5 µm"). Here Ti serves as a bonding layer, Pt serves as a solder barrier layer (for preventing diffusion of a solder material to the Ti film) when another metal is soldered onto the Au film, and Au serves as a main wiring layer and also as a layer for securing the wire bonding capability. The Ti film, Pt film, and Au film of the laminated structure are collectively patterned using anion milling apparatus. With respect to the total thickness of the metal film for the bonding pads, according to the experiments of the inventors, the effect of the embodiment appears in the range of 0.02 to 30 µm and is more pronounced in the range of 0.02 to 5 µm.

There is provided an Au conductive bump 4 on a surface of the first bonding pad 31. The conductive bump 4 is formed in such a way that an Au wire of 25 µm is melted to form an Au ball (100 µm in diameter) which is then ball banded to the bonding pad 31. It is necessary that the member of the conductive bump can be bonded to the bonding pad 31 by ultrasonic welding, and Al may be used instead of Au. Here the height of the conductive bump is from 40 to 80 µm.

The conductive bump 4 formed on the first bonding pad 31 is electrically connected to the second bonding pad by an Au conductive wire 5. Aball-bonding 51, which is the first bonding of wire bonding, is formed on the second bonding pad 32 with no conductive bump therein. A second bonding 52, which is the second bonding of wire bonding, is formed on the conductive bump 4 formed on the first bonding pad 31.

Wire bonding is to bond a conductive wire of Au or other material and an electrode by diffusing a metal by ultrasonic waves. In wire bonding, the substrate may be damaged by ultrasonic waves applied for the connection. Particularly, as has been described above, when the resin insulating film such as the polyimide film is provided directly below the bonding pad, the polyimide film and the bonding pad may be exfoliated by ultrasonic waves, or the polyimide itself may be broken. In the case of wire bonding, such a phenomenon takes place in the second bonding, namely, in wedge bonding. This is because in the case of ball-bonding, the force is not easily applied to the polyimide as ultrasonic waves are attenuated due to the presence of the ball, while in wedge bonding there is practically no area to attenuate ultrasonic waves. With the structure according to the embodiment, the ultrasonic waves applied to the polyimide are attenuated due to the presence of the bump corresponding to the ball-bonding, so that it is possible to avoid the phenomenon of exfoliation or fracture.

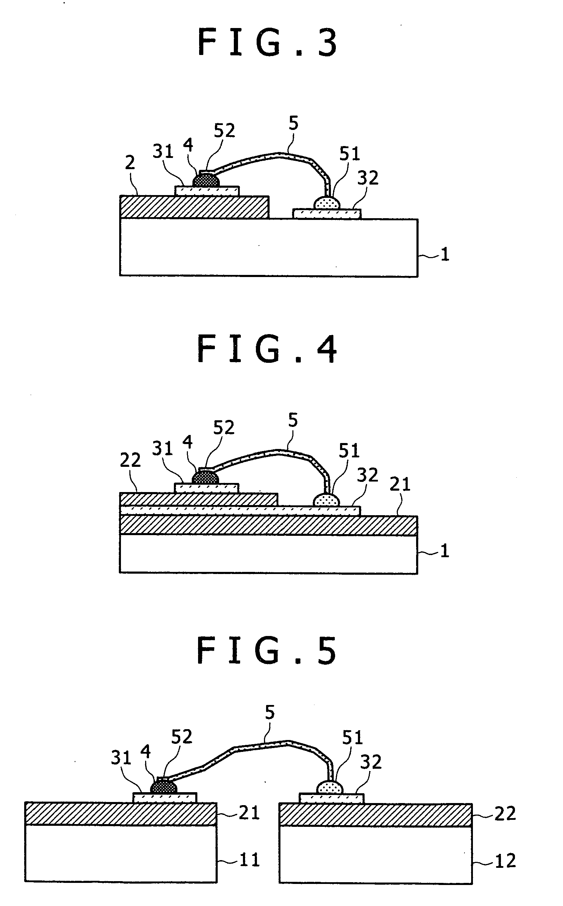

Incidentally, the structure of the electronic circuit board according to the embodiment may also be those shown in Figs. 3 to 5.

In Fig. 3, only the first bonding pad 31 is formed on the polyimide film 2 and the second bonding pad 32 is formed on the substrate 1. Even with such a structure, the effect of the embodiment is similar to that of Fig. 2 by providing the conductive bump 4 on the first bonding pad 31 formed on the polyimide film 2.

In Fig. 4, a polyimide layer 21 is formed on the substrate 1, on which a metal film layer to be the second bonding pad 32 is formed and a polyimide layer 22 is further formed on the metal film layer. The first bonding pad 31 is formed on the upper layer polyimide film 22. With such an electronic circuit board, the same effect as that of Fig. 2 can be obtained by forming the conductive bump 4 on the first bonding pad 31 and electrically connecting the conductive bump 4 and the second bonding pad 32 by the bonding wire 5.

Further Fig. 5 shows the structure that is provided with two substrates 11, 12. Formed on the substrate 11 is the polyimide film 21 on which the bonding pad 31 is formed. Formed on a substrate 12 is the polyimide film 22 on which the second bonding pad 32 is formed. In the embodiment, although the polyimide film 22 is also provided on the side of the substrate 12, it may be configured that the polyimide film 22 is not present on the substrate 12 as a matter of course. The same effect as that of Fig. 2 can be obtained by forming the conductive bump 4 on the first bonding pad 31 and electrically connecting the conductive bump 4 and the bonding pad 32 by the bonding wire 5.

In the embodiment aluminum nitride was used as the substrate, but there may also be used ceramic substrates such as A1203 (alumina) and SiC (silicon carbide), a semiconductor substrate such as Si (silicon), a glass epoxy substrate represented by FR-4, a glass substrate, and the like. Further polyimide was used as the resin insulating film, but polyamide may be used instead of polyimide. Alternatively, epoxy resin or acrylic resin, or materials containing such resins as main component may also be used.

The member of the bonding pad may include Al (aluminum) or Au, or a material containing Al as main component. With respect to the above described structure of the metal film that constitutes the bonding pad, the member to which the conductive wire can be bonded shall be present on the film surface. The metal film constituting the bonding pad and the wiring layer described below, may have a laminated structure of such as Cr (chrome)/Al, Ti/Al, Ti/Ni (nickel)/Au, Cr/Cu(copper)/Au, instead of the laminated structure of Ti/Pt/Au as used in the embodiment.

In the case of using the laminated structure of Cr/Cu/Au as the metal film, it is possible to form Cr film, Cu film, and Au film (the thicknesses are, for example, 0.1/0.5/0.1 µm, respectively) in the order from the side of the substrate 1 (the side of the substrates 11, 12) sequentially by one sputtering apparatus. In the laminated structure, the Cr film serves as a bonding layer, the Cu film serves as a main wiring layer, and the Au film serves to prevent the Cu surface from being oxidized and to secure the wire bonding capability. The pattern is formed by etching using aqueous solutions of iodine and ammonium iodine for the Au film and the Cu film as well as using an aqueous solution of ferricyanide for the Cr film, respectively. The total film thickness of the relevant laminated structure preferable as the metal film for the bonding pad is the same as that of the laminated structure of Ti/Pt/Au.

The availability of the variation of the above described substrate, resin insulating film, and metal film (bonding pad) is the same as in other embodiments described below.

Incidentally, the second bonding of wire bonding is sometimes referred to as stitch bonding. The ball-bonding, wedge bonding, and stitch bonding are the method of ultrasonic bonding. Further the bonding pad is eventually a portion being bonded, including the meaning of wiring. The bump means a protruding portion.

### [Embodiment 2]

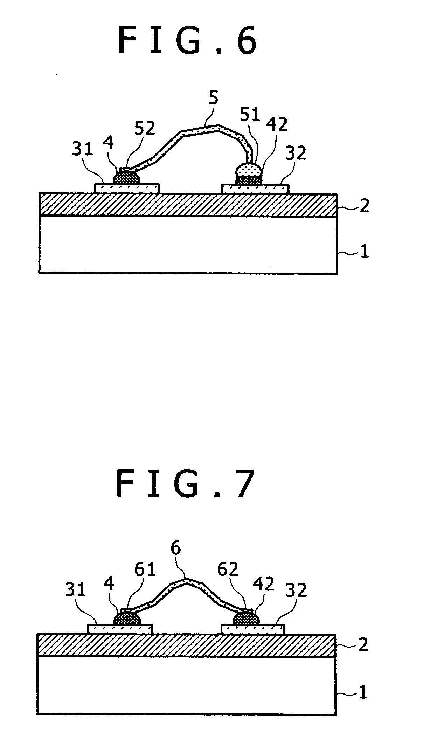

Next a second embodiment of the present invention will be described with reference to Figs. 6 and 7. Here Figs. 6 and 7 are cross-sectional views each showing an electronic circuit.

First Fig. 6 will be described. In the second embodiment, similarly to the first embodiment, the polyimide film 2 is formed on the surface of the substrate 1. Aluminum nitride was used for the substrate 1, and polyimide was used for the polyimide film 2. The film thickness of polyimide was set to 2 µm.

The first bonding pad 31 and the second bonding pad 32 are formed on the polyimide film 2. The metallization of the bonding pads 31, 32 is Cr/Al with the film thicknesses of 0.1/1.0 µm, respectively.

Cr/Al was formed sequentially by one sputtering apparatus, without breaking vacuum. Here Cr is a bonding layer, Al is both a wiring layer and a wire bonding layer. The pattern is formed by etching using an aqueous solution of the mixture of phosphoric acid, acetic acid, and nitric acid for Al, as well as using an aqueous solution of cerium ammonium nitrate and perchloric acid for Cr, respectively.

On the first bonding pad 31 and the second bonding pad 32, a first conductive bump 41 and a second conductive bump 42 are provided, respectively. In other words, the difference between the present embodiment and the first embodiment is that the conductive bump is formed both on the bonding pads 31, 32. Au was used as the member of the conductive bumps 41, 42.

The conductive bump 41 formed on the first bonding pad 31 is electrically connected to the conductive bump 42 formed on the second bonding pad 32 by the conductive wire 5. In the embodiment, the conductive bumps were formed by a ball bonder using an Au wire. The ball-bonding 51, which is the first bonding of ball-bonding, is formed on the conductive bump 42 formed on the second bonding pad 32. The ball-bonding 52, which is the second bonding of ball-bonding, is formed on the conductive bump 41 formed on the first bonding pad 31. However, in the embodiment, the conductive bumps for alleviating ultrasonic waves are formed on the respective bonding pads, so that the setting positions of the ball-bondings may be reversed from those described above. With this configuration, it is possible to obtain an excellent connection without failure by wire bonding, such as exfoliation or resin facture.

As descried above, in the second embodiment, wedge bonding may be performed to either one of the bonding pads 31 and 32. With this structure, as shown in Fig. 7, the same effect can be obtained when a conductive wire 6 is connected by applying wedge bondings 61, 62 on the conductive bumps 41, 42 by a wedge bonder.

Incidentally, with respect to the structure of the electronic circuit board, similarly to the first embodiment, the same effect can be obtained with the structures shown in Figs. 3 to 5, instead of those shown in Figs. 6 and 7.

### [Embodiment 3]

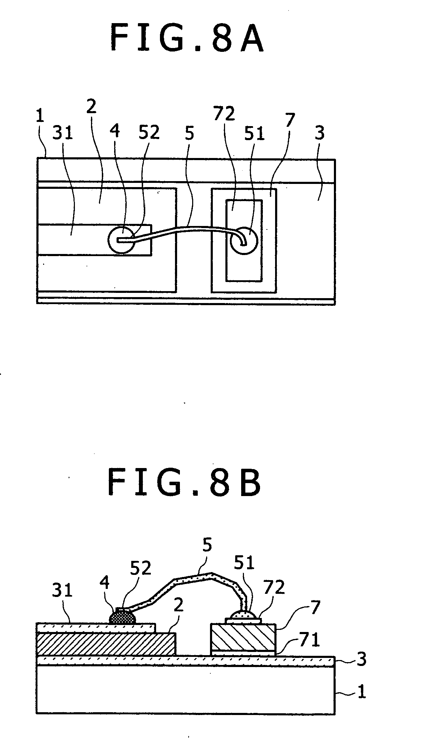

Next, another mode of the present invention will be described as a third embodiment with reference to Fig. 8. Here Fig. 8 includes a top view and a cross-sectional view of an optical module used for optical communication, optical recording, and the like.

In Fig. 8, a wiring layer 3 of Ti/Pt/Au (thicknesses of 01/0.2/0.5 µm) is formed on the aluminum nitride substrate 1. The resin insulating layer 2 of polyimide film (thickness of 2 µm) is formed in portion of the upper layer of the wiring layer 3. Further the bonding pad 31 of Ti/Pt/Au (thicknesses of 0. 1/0.2/0.5 µm) is formed on the resin insulating layer 2. The bonding pad 31 also servers as wiring. The bump 4 of Au formed by a ball bonder is provided on the bonding pad 31.

A semiconductor laser 7 is mounted to portion of the wiring layer 3 on the substrate 1, in which the resin insulating layer 2 is not present, by solder or other suitable means. The semiconductor laser 7 emits light when an electrode 71 in the bottom thereof and an electrode 72 in the top thereof are electrically connected to the wiring and when current is applied thereto. The electrode 71 is bonded to the wiring layer 3 by solder, although which is not shown in the figure.

The electrode 72 is corresponds to the second bonding pad 32 in Fig.1. The conductive bump 4 on the bonding pad 31 is connected to the electrode 71 of the semiconductor laser 7 by the conductive wire 5. In the embodiment, the conductive bump 4 was formed by a ball bonder using an Au wire. The ball-bonding 51 which is the first bonding of ball-bonding is formed on the electrode 72, and the wedge bonding 52 which is the second bonding of wire bonding is formed on the conductive bump 4.

The wiring layer 3, the insulating resin layer 2, and the bonding pad 31 also serving as the wiring, form microstrip transmission lines, so that it is possible to effectively transmit an electrical signal of 10 Gbit/s to the semiconductor laser. Also with this configuration, it is possible to obtain a highly reliable optical module. The insulating resin film of the embodiment is thin with a thickness of 2 µm, so that there is also an advantage that a very small transmission line can be provided with an impedance of 50Ω.

Incidentally, the embodiment can be applied not only to the semiconductor laser, but also to optical semiconductor elements such as photodiode and optical modulator, as well as chip components such as thermistor and capacitor.

### [Embodiment 4]

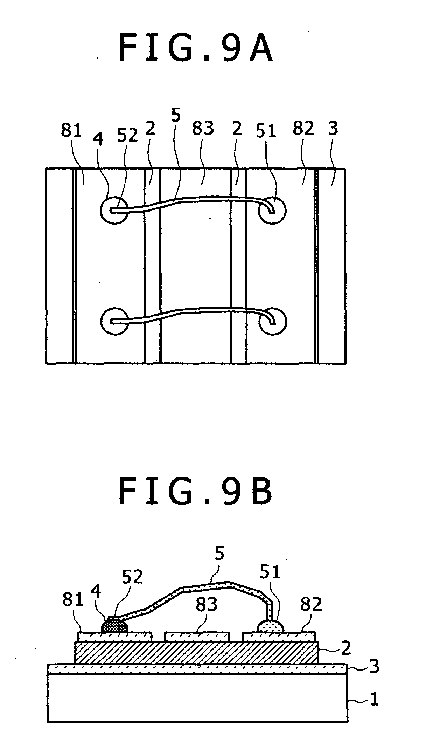

Another mode of the present invention will be described as a fourth embodiment with reference to Fig. 9. Here Fig. 9 includes a top view and a cross-sectional view of high-frequency transmission lines.

In Fig. 9, the wiring layer 3 of Cr/Cu/Au is formed on the surface of the aluminum nitride substrate 1. The resin insulating layer 2 of polyimide film is formed in portion of the upper layer of the wiring layer 3. Further on the resin insulating layer 3, wiring layers 81, 82, 83 of Cr/Cu/Au are formed. The wiring layers 81, 82, 83 are formed with electrical signal wirings, taking on the configuration of coplanar waveguide with 81, 82 as ground lines and 83 as a signal line.

In the case of the coplanar waveguide, it is necessary to equalize the potentials of the ground lines 81, 82 on the left and right sides in order to provide excellent transmission characteristics. As a means of equalizing the potentials, a way of electrically connecting the left and right ground lines by a conductive wire is used. In other words, 81 and 82 shown in Fig. 9 correspond to the bonding pads 31 and 32 of the first embodiment. The conductive bump 4 of Au is formed on the ground line 81. The conductive bump 4 and the ground line 82 are electrically connected by the conductive wire 5.

The coplanar waveguide according to the embodiment is highly reliable with a thin dielectric film of 2 µm, so that there is also an advantage that a very small transmission line can be provided with an impedance of 50Ω.

### [Embodiment 5]

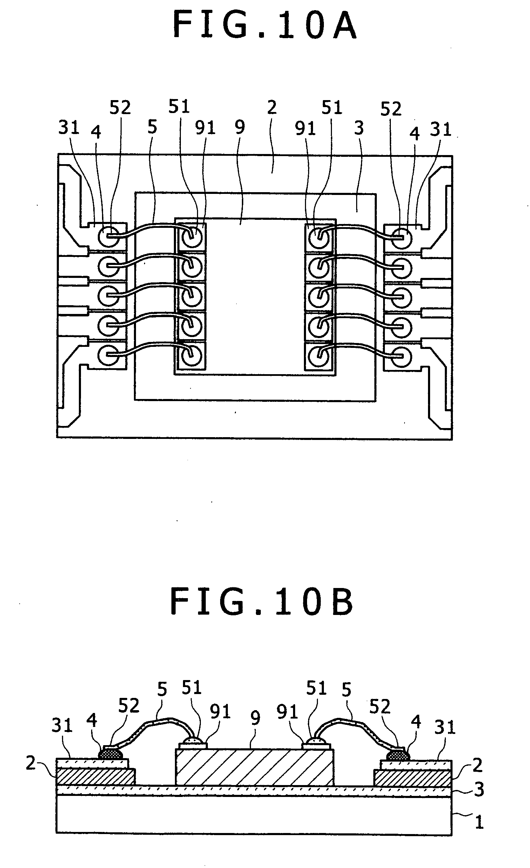

Another mode of the present invention will be described as a fifth embodiment with reference to Fig. 10. Here Fig. 10 includes a top view and a cross-sectional view of a semiconductor device on which a semiconductor chip 9 is mounted.

The wiring layer 3 of Cr/Cu/Au is formed on the aluminum nitride substrate 1, and the polyimide film 2 is formed in portion of the upper layer thereof. Plural bonding pads 31 are formed on the surface of the resin insulating layer 2. Here the bonding pad 31 also serves as a wiring layer. The conductive bump 4 of Au formed by a ball bonder is provided on the bonding pad 31.

The semiconductor chip 9 is die-bonded to the wiring layer 3 on the substrate 1. An electrode 91 is present on the top surface of the semiconductor chip 9. The electrode 91 of the semiconductor chip corresponds to the second bonding pad 32 in Fig. 1. The conductive bump 4 on the bonding pad 31 is connected to the electrode 91 of the semiconductor chip 9 by the conductive wire 5. The conductive wire is formed by a wire bonder using an Au wire. The ball-bonding 51 which is the first bonding of wire bonding is formed on the electrode 91, and the second bonding 52 is formed on the conductive bump 4. With this configuration, it is possible to provide a highly reliable semiconductor device.

### [Embodiment 6]

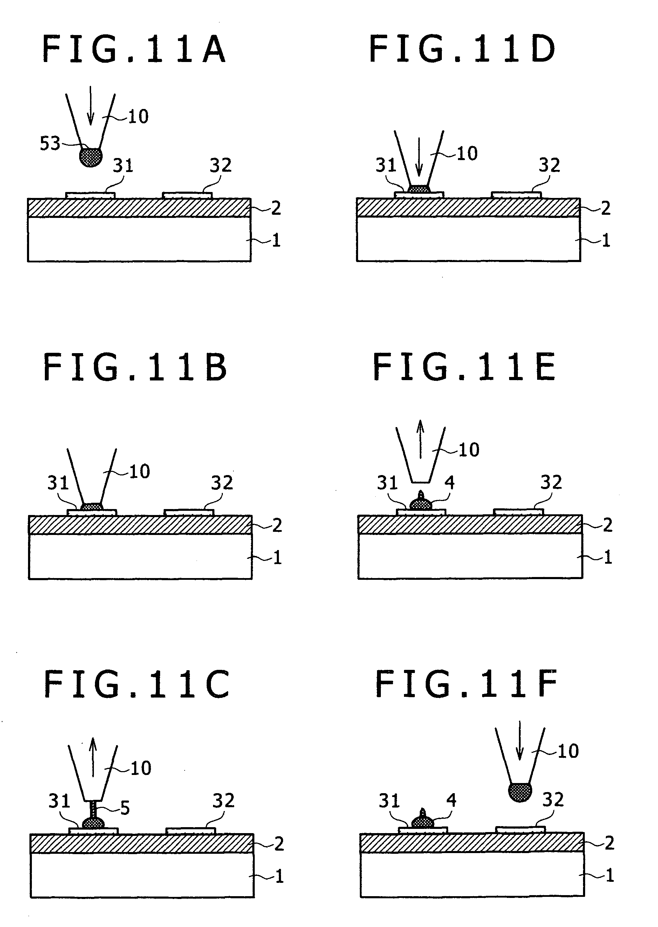

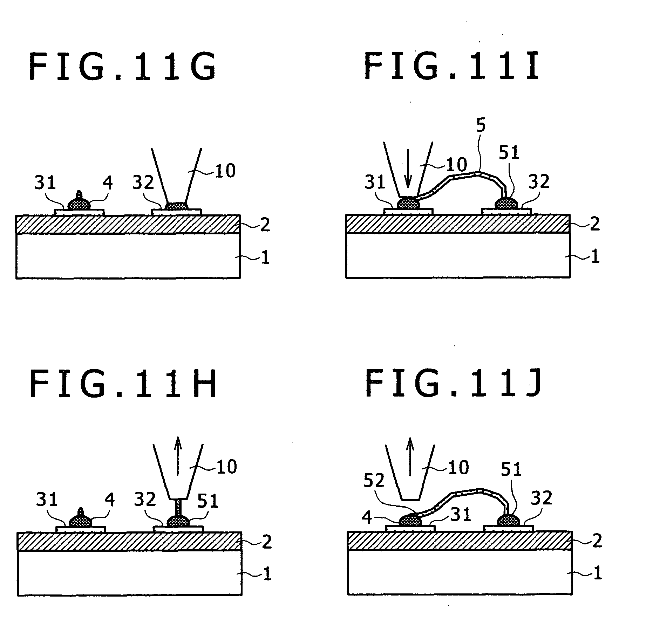

A method for manufacturing an electronic circuit, which is another mode of the present invention, will be described as a sixth embodiment with reference to Fig. 11. Here Fig. 11 includes views illustrating the process of wire bonding.

In Fig. 11A, the polyimide film 2 is formed on the aluminum nitride substrate 1 on which the first bonding pad 31 and the second boning pad 32 are formed. Here the bonding pads 31, 32 are Ti/Pt/Au (0.1/0.2/0.5 µm).

First, a conductive bump is formed on the first bonding pad 31. A wire bonder using an Au wire was used for the formation of the bump. A capillary 10 of the wire bonder is approached to the first bonding pad 31. In Fig 11B, the Au wire 5 with a ball 53 formed at an end thereof is brought into contact with the pad 31 to which an ultrasonic output is applied, and thus the first bonding is performed. In this way the first bonding pad 31 and the Au ball 53 are ultrasonically welded together.

Next, the capillary 10 is once raised in Fig. 11C. The capillary 10 is landed again directly on the ball 53 bonded to the pad 31, and thus the second bonding is performed (Fig. 11D). Then the capillary 10 is raised to cut the Au wire therefrom, and thus the conductive bump 4 is completed (Fig. 11E).

Next, the capillary 10 is approached to the second bonding pad 32 in Fig. 11F, and then the pad 32 and the Au ball 51 are ultrasonically welded by ball-bonding (Fig. 11G). The capillary is once raised (Fig. 11H). The capillary 10 is approached to the first bonding pad 31 while a loop of the wire is formed. The capillary 10 is landed directly on the conductive bump 4 formed on the surface of the first bonding pad 31, and then the conductive bump 4 and the conductive wire 5 are bonded by applying ultrasonic waves again (Fig. 11I). Finally the capillary 10 is raised to cut the Au wire therefrom, and thus the bonding 52 is formed on the conductive bump 4 (Fig. 11J).

With the manufacturing process described above, it is possible to provide a method for manufacturing an electronic circuit with excellent connectivity, but with no failure such as exfoliation at the interface between the resin and the pad, or fracture of the resin, even when wire bonding is performed to the bonding pad on the resin insulating film.

Incidentally in the above described embodiment, the bump formation and wire bonding were performed by one wire bonder. However, it is also possible that the ball bumping process from Fig. 11A to Fig. 11E is performed by a dedicated bonder and the wire bonding process from Fig. 11F to Fig. 11J is performed by a wire bonder. Even with a structure in which a bonding pad of metal thin film is formed on a resin insulating film, it is possible to realize an excellent bonding state for performing wire bonding to the bonding pad.

## Claims

1. An electronic circuit comprising:
a substrate;
a resin insulating film formed on the substrate; and
a metal film formed on the resin insulating film,
said electronic circuit being **characterized in that** a bump to which a conductive wire is ultrasonically bonded is further formed on said metal film.

2. An electronic circuit comprising:
a substrate;
a resin insulating film formed on the substrate;
a first boning pad of metal film formed on a surface of the resin insulating film;
a bump formed on the first bonding pad; and
a second bonding pad electrically connected to said first bonding pad,
said electronic circuit being **characterized in that** said electrical connection is made by a metal wire connecting between said second bonding pad and said bump.

3. An electronic circuit comprising:
a substrate;
a resin insulating film formed on the substrate; and
a first wiring, a second wiring, and a third wiring that are formed by patterning a metal film formed on a surface of the resin insulating film, wherein said first wiring and said third wiring are electrically connected with said second wiring interposed therebetween,
said electronic circuit being **characterized in that** a bump is formed on said first wiring, and that the bump and said third wiring are connected by a metal wire.

4. The electronic circuit according to any of claims 1 to 3, **characterized in that** said resin insulating film is a member containing any of polyimide, epoxy resin, and acrylic resin, as a main component.

5. The electronic circuit according to any of claims 1 to 3, **characterized in that** said bump is either Au or Al, or a member containing either of such materials.

6. The electronic circuit according to any of claims 1 to 3, **characterized in that** a surface layer of said metal film is either Au or Al, or a member containing either of such materials.

7. The electronic circuit according to claim 6, **characterized in that** the film thickness of said metal film is over 0.02 µm but not over 30 µm.

8. A method for manufacturing an electronic circuit, comprising the steps of:
forming a resin insulating film on a substrate;
forming a metal film on said resin insulating film;
patterning said metal film; and
forming a bump to which a conductive wire is ultrasonically bonded, on the patterned metal film.

9. A method for manufacturing an electronic circuit including a substrate, a resin insulating film formed on the substrate, and first and second bonding pads of metal film formed on a surface of the resin insulating film,
said method comprising the steps of:
forming a conductive bump on said first bonding pad;
performing a first bonding of wire bonding to said second bonding pad; and
performing a second bonding of wire bonding to said conductive bump and electrically connecting said first bonding pad with said second bonding pad.
